Europäisches Patentamt

European Patent Office

Office européen des brevets

(19)

(11) EP 0 641 444 B1

(12) EUROPEAN PATENT SPECIFICATION

(45) Date of publication and mention
of the grant of the patent:
**20.05.1998 Bulletin 1998/21**

(21) Application number: **92924737.7**

(22) Date of filing: **30.11.1992**

(51) Int Cl.[6]: **G01R 15/24**, G01R 29/12

(86) International application number:
**PCT/FI92/00326**

(87) International publication number:
**WO 93/12435 (24.06.1993 Gazette 1993/15)**

(54) **OPTICAL VOLTAGE AND ELECTRIC FIELD SENSOR BASED ON THE POCKELS EFFECT**

OPTISCHER SPANNUNGS- UND ELEKTRISCHER FELD-SENSOR NACH POCKELS-EFFEKT
WIRKEND

DETECTEUR OPTIQUE DE TENSION ET DE CHAMP ELECTRIQUE BASE SUR L'EFFET
POCKELS

(84) Designated Contracting States:
**AT BE CH DE DK ES FR GB IE IT LI NL PT SE**

(30) Priority: **11.12.1991 FI 915818**

(43) Date of publication of application:
**08.03.1995 Bulletin 1995/10**

(73) Proprietor: **IMATRAN VOIMA OY**
**00100 Helsinki (FI)**

(72) Inventor: **ENGLUND, Marja**
**SF-02780 Espoo (FI)**

(74) Representative: **Knott, Stephen Gilbert et al**
**MATHISEN, MACARA & CO.**
**The Coach House**
**6-8 Swakeleys Road**
**Ickenham Uxbridge UB10 8BZ (GB)**

(56) References cited:
**GB-A- 2 212 907**

- **IEEE Transactions on Power Delivery, Volume PWRD2, No. 1, January 1987, T. MITSUI et al., "Development of Fiber-Optic Voltage Sensors and Magnetic-Field Sensors", page 87 - page 93, figure 1.**
- **Rev. Sci. Instrum., Volume 60, No. 7, July 1989, KUNIHIKO HIDAKA et al., "Simultaneous Measurement of Two Orthogonal Components of Electric Field Using a Pockels Device", page 1252 - page 1257, figures 1,3.**
- **IEEE Journal of Quantum Electronics, Volume QE-19, No. 7, July 1983, E.A. BALLIK et al., "Measurement of High-Voltage Pulses Employing a Quartz Pockels Cell", page 1166 - page 1168, figure 5.**

**Description**

The invention relates to an optical sensor for voltage and electric field based on the Pockels effect in accordance with the preamble of claim 1.

The function of the present voltage and electric field sensor is based on the electro-optical Pockels effect that is exhibited e.g. by the following materials: $LiNbO_3$, $LiTaO_3$, KDP, ADP, and $Bi_4Ge_3O_{12}$. According to the Pockels effect the plane of polarization of polarized light alters when the light is passed through such a material in the presence of an electric field. The Pockels effect is exhibited typically by crystalline materials that do not possess a centre of symmetry.

Distribution of refractive index of the crystal used as the optical sensor is altered by the voltage being measured. The resultant difference in refractive index depends on the intensity of electric field. The difference in refractive index produces a phase difference between the mutually perpendicularly polarized components of the plane polarized light passed through the material. Depending on structure and orientation of the crystal, a longitudinal or a transverse effect occurs. In the longitudinal effect the path of the ray and the electric field are parallel, and in the transverse effect they are perpendicular to each other.

A measurement system based on the Pockels effect comprises typically an optical sensor, optical fibres, and an electronic unit that transmits infrared radiation modulated by the voltage of electric field being measured, through the fibres to the sensor. Information about voltage or electric field is obtained by means of measuring the intensity changes of the radiation returned by the sensor.

A voltage sensor having, in sequence, a polarizer, a waveplate, a crystal of $Bi_{12}SiO_{20}$ and an analyser is disclosed in IEEE Transactions on Power Delivery, vol. PWRD-2, No. 1 (January 1987), pages 87-93. An electric field sensor having a thin protective coating of silicone is disclosed in GB 2212907A.

Optical voltage sensors based on the Pockels effect are developed for various high voltage measurements. Most of the embodiments are designed to function in the 50-60 Hz frequency range. A few demonstrations have been carried out to measure also rapid changes in voltage. Problems of the high frequency embodiments have been the high frequency high voltage endurance and the frequency range of the measurement system. For example, in the high frequency drying 13.56 MHz frequency and 10 kV voltage are used.

The aim of the present invention is to overcome the disadvantages of the prior art technology and to achieve an entirely new kind of optical sensor of voltage and electric field based on the Pockels effect.

The invention is based on filling the inner structure surrounding the crystal of the sensor with silicone, so that air gaps in the sensor are avoided.

More specifically, the sensor in accordance with the invention is characterized by what is stated in the characterizing part of claim 1.

The invention provides outstanding benefits.

Silicone is easily attachable to surfaces of ceramical materials and optical components. Silicone protects from humidity, improves voltage endurance and increases the frequency response in the 300 Hz - 30 MHz range, damping the vibration of the crystal used in the sensor. Using silicone makes it feasible to improve sensitivity and dynamics of the sensor while not impairing its voltage endurance. Measurements have indicated that the voltage endurance was increased approx. five times by using silicone. At the same time the measurement range of the sensor was enlarged. The silicone used has such qualities (extinction coefficient $\tan\delta$ is small) that it is not heated by an intensive high frequency field, making thus its use very suitable also in the optical sensors of high frequency dryers.

In the following, the invention will be examined in detail with help of the following exemplifying embodiments illustrated in the attached drawings.

Figure 1 is a schematic representation of a measurement system using a sensor in accordance with the invention.

Figure 2 is an alternative measurement system using a sensor in accordance with the invention.

Figure 3 represents the optical signal of the sensor in accordance with the invention in relation to the voltage being measured.

Figure 4 is a side view of the basic components of the sensor in accordance with the invention.

Figure 5 is a sectional side view of a sensor in accordance with the invention.

Figure 6 is a sectional side view of a second sensor in accordance with the invention.

Figure 7 is a sectional side view of a sensor in accordance with the invention for measuring the electric field.

Figure 8 is a sectional side view of a third sensor in accordance with the invention.

Figure 9 is a sectional side view of a fourth sensor in accordance with the invention.

Figure 10 is a sectional top view of a fifth sensor in accordance with the invention.

Figure 11 is a sectional side view of the sensor illustrated in Fig. 10.

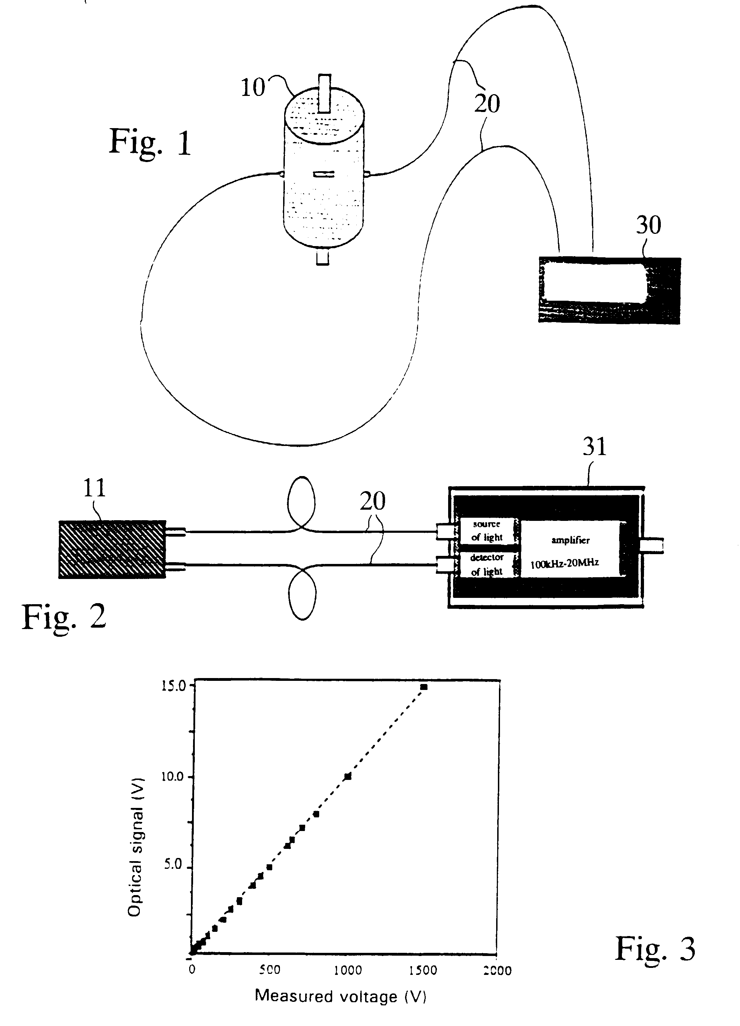

The optical measurement system shown in Fig. 1 comprises optical sensor 10, optical fibres 20 and electronic unit 30 that transmits infrared radiation modulated by the voltage being measured, through the fibres 20 to the voltage sensor 10. Measuring the intensity changes of the radiation returned by the sensor 10, information about the voltage or electric field is obtained. Distortions of the measurement signal caused by the attenuation of the radiation level possibly occurring in the whole measurement system are compensated in the electronic unit 30.

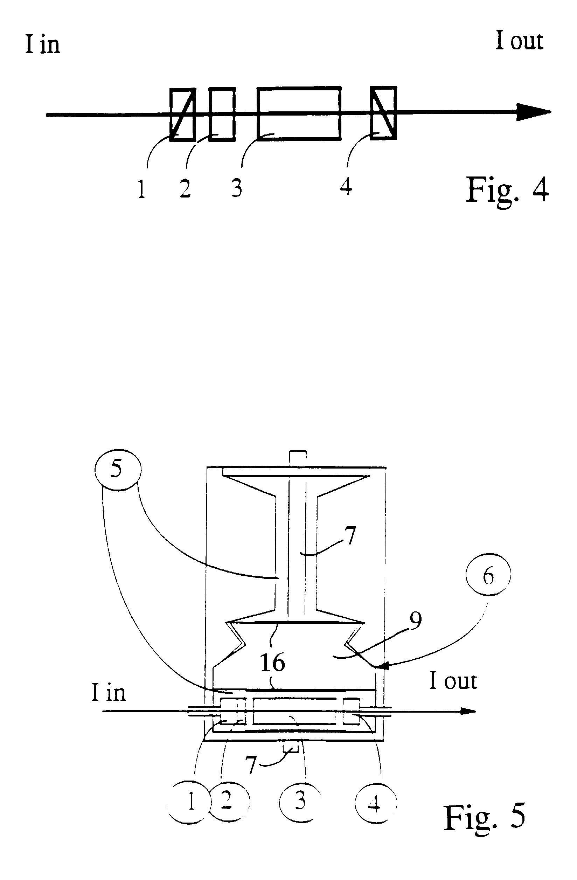

The function of the optical voltage and electric field sensor is based on the electro-optical Pockels effect. In accordance with the effect the plane of polarization of polarized light alters when the light is passed in the presence of an electric field through a material exhibiting the Pockels effect. A sensor utilizing such an active material can thus be used to measure high frequency voltage without applying electrical power on the sensor. The optical sensor is isolated from the voltage being measured by fibres, because galvanically connected sensor and measurement device would have a side effect on the measurement result. The optical sensor differs from other similar sensors functioning on the same principles by its speed (30 MHz), and particularly by its construction. The construction of the sensor 10 is illustrated in detail in Fig. 4 - 9.

In the following, theory of the effect is described in detail.

In accordance with the Pockels effect an electric field causes alteration in the refractive index of a material that is proportional to the electric field.

$$(1) \qquad \Delta n = n_0{}^3 r_{ij,k} E_k,$$

where

$\Delta n =$ the difference in refractive index caused by the electric field, which difference is produced between two mutually perpendicularly polarized components of a light wave traversing the crystal,

$n_0 =$ the refractive index of the crystal without the presence of the electric field,

$r_{ij,k} =$ the linear electro-optical coefficient, and the indexes i and j represent the planes of the electric field (of the polarization) of the optical wave, acquiring values 1, 2 and 3, and k (1, 2 or 3) indicates the direction of the electric field applied to the crystal and

$E_k =$ the electric field applied to the crystal.

Due to the symmetries of crystals the index pair (ij) can be replaced by six combinations (11) = 1, (22) = 2, (33) = 3, (24) = 4, (13) = 5, and (12) = 6, so that equation (1) can be written as

$$(2) \qquad \Delta n = n_0{}^3 r_{h,k} E_k,$$

h = 1, 2, 3, 4, 5 or 6.

Basic components of a typical sensor for measuring voltage and electric field utilizing the Pockels effect are shown in Fig. 4. Light passes via polarizer 1 and phase shift plate 2 through optical sensor element 3. The optical sensor element 3 exhibits the Pockels effect. A phase difference between the mutually perpendicularly polarized components of the plane polarized light is produced by the voltage being measured. The phase difference causes alteration in the plane of polarization of the light. The change in the plane of polarization is detected by the second polarizer 4 acting as an analyzer. The electric intensity perceived by the sensor element 3 determines the intensity of light passing through the analyzer 4. If the planes of polarization of polarizer 1 and analyzer 4 are perpendicular and the phase shift plate gives a phase difference of 90°, the intensity of the emergent light is given by the expression

$$(3) \qquad P = P_0/2 \ (1 - \pi/V\pi \ X \ V_0 \sin \omega t)$$

where

$P =$ intensity of the emergent light

$P_0 =$ intensity of the incident light

$V_\pi =$ half wave voltage, i. e. voltage that causes the plane of polarization to rotate 90° in the sensor

$V_0 \sin \omega t =$ alternating voltage with the frequency $\omega, (V_0$ is the amplitude and t is the time) applied on the sensor element.

Crystals exhibiting the Pockels effect, e.g. $LiNbO_3$, $LiTaO_3$, KDP, ADP, and $Bi_4Ge_3O_{12}$ have been used as the material of the optical sensor. The alteration in the refractive index caused by the electric field depends on the crystal symmetry. For example, in the $Bi_4Ge_3O_{12}$ crystal having dimension d in the plane of the electric field and 1 in the direction of the light wave, [110]-oriented electric field causes a 180° phase difference between the [110] and [001]-oriented components of the plane polarized light if the voltage applied across the crystal is

$$(4) \qquad V\pi = (\lambda/2 \, n_0^3 r_{41})(d/1),$$

that causes the plane of the polarization to rotate 90°.

According to Fig. 2, sensor 11 in an alternative measurement system has a prism for deviating the ray. A sensor of this kind is described in detail in Fig. 10 - 11. In this figure general parts of the electronic unit 31 are represented: source of light emitting the light into optical fibres 20, detector of light that detects the light returned from sensor 11 through the optical fibres, and the amplifier for amplifying the detected signal. In high frequency embodiments the amplifier has to be able to function in a frequency range of e. g. 10 MHz - 30 MHz. With the sensors for high voltage tests an ability to function in the frequency range 20 Hz - 30 MHz is required.

According to Fig. 3 the minimum measurable voltage level is determined by the characteristics of the sensor and the signal/noise ratio of the light detector and the amplifier. The maximum measurable voltage is determined by the breakdown endurance of the sensor. The crystal in the sensor is adjusted to provide in theory a linear functioning of the sensor up to 3 kV when voltage being measured is connected by wires directly to the conducting surfaces of the crystal. The figure shows the dependence of the light intensity passed through the sensor on the electric field being measured. when utilizing a $\lambda/4$-phase shift plate (where $\lambda$ is the wave length of the light) the working point is set on the linear part of the curve. The sensor output is nearly linear in relation to the voltage being measured, when the maximum voltage connected to the conductive surfaces of the crystal is $V_{max} \leq 1/6 \, V_{\lambda/2}$.

The estimated resolution of the whole measurement system was 0.5 V in the frequency range 30 Hz - 100 kHz and 10 V in the frequency range 100 kHz - 30 MHz, and the estimated accuracy was ±0.5 / (30 Hz - 100 kHz) and ±1.0 / (100 kHz - 30 MHz).

According to Fig. 4 the basic components of the sensor in accordance with the invention listed in the sequence as passed by the light are polarizer 1, phase shift plate 2, crystal 3, and polarizer 4 acting as an analyzer. Crystal 3 applicable with the embodiment is oriented so that it enables the electric field being measured to produce the required alteration in plane of the plane polarized light traversing the crystal. Polarizers 1, 4 and optical shift plate 2 are oriented so that the change in the intensity of the light traversing the whole sensor is directly proportional to the voltage being measured.

In Fig. 5 the basic components are inserted into the actual sensor. In addition. for potential division the sensor is provided with capacitor 6 and wire 7 to lead the measurement signal to crystal of the sensor 3. The inner space of the sensor is filled with silicone 5. As an insulating material 9 of capacitor 6 favourably ceramics or alternatively polypropylene is used. Conducting plates 16 of the capacitor 6 are formed onto the surface of ceramics 9. Particularly suitable ceramics for the invention is the commercial product *Makor* having a dielectric constant $\varepsilon$ of 5.6. Using this embodiment a good voltage endurance and an appropriate resolution in high frequency applications is achieved.

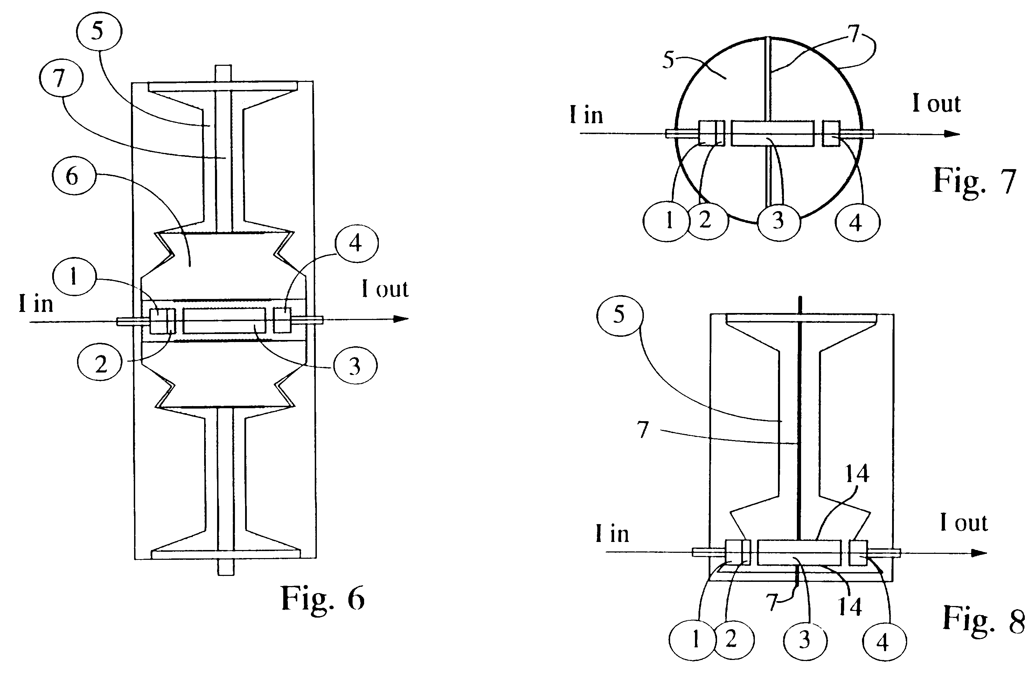

The embodiment according to Fig. 6 utilizes a symmetrical potential dividing on both sides of crystal 3.

In the electric field sensor according to Fig. 7 no potential dividing capacitor is used, but the field is brought by wires 7 directly to the surface of crystal 3. The whole sensor structure is surrounded by two semispherical conductive covers 7 isolated from each other. The inner space of the sensor is filled with silicone 5.

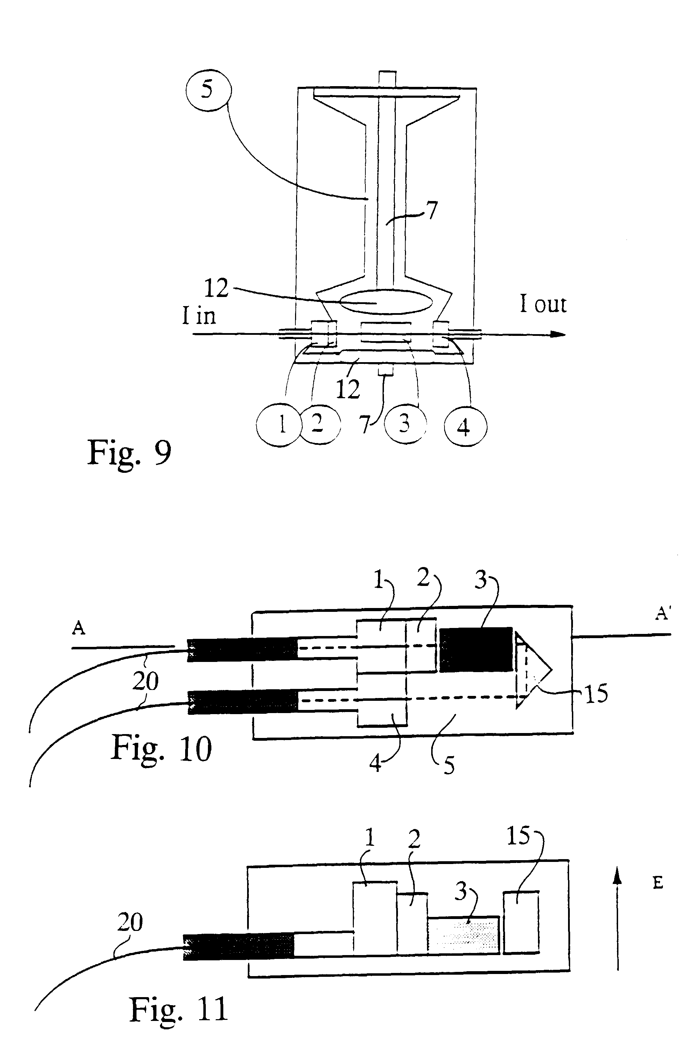

The embodiment according to Fig. 8 corresponds the embodiment shown in Fig. 5 accomplished without potential dividing capacitor 6. The field is brought by wires 7 to metallizations 14 that are made directly on surface of crystal 3. The inner space of the sensor is filled with silicone. Mesurements demonstrated that due to using silicone the voltage endurance of the sensor improved approx. five times.

In the embodiment according to Fig. 9 the voltage being measured is brought by wires 7 to conductive ball or plate 12 that is situated at a distance from crystal 3. Because the inner structure is filled with silicone 5, the gap between plate 12 and crystal 3 acts as a potential divider. The electric field is confined within silicone, because silicone has a smaller dielectric constant than the crystal: $\varepsilon = 2,9 < \varepsilon_{crystal} = 16$. Silicone 5 has a high voltage endurance and also its extinction coefficient is small, therefore silicone does not warm up even in an intensive high frequency electric field.

The sensor according to Fig. 10 and 11 corresponds by its basic components to the sensors shown in Fig. 4 - 9. The main difference is the prism 15 that returns the light signal passed through crystal 3. As usually, there are polarizers 1 and 4 on the path of the light, and phase shift plate 2 is on the path between the first polarizer 1 and crystal 3.

In the following, the properties of the significant components of the invention are exemplified:

Crystal 3

$Bi_4Ge_3O_{12}$:

- 43m-crystal symmetry; cubic,
- Refractive index n = 2,0975 (633 nm)
- Temperature dependence of refractive index $(dn/dT)/n = 2 \cdot 10^{-5}$/K (633 nm)
- Thermal coefficient of expansion $(dH/dT)/h = 1\ 10^{-6}$/K
- $r_{41} = 0,95 \cdot 10^{-12}$m/V
- $n_0^3 r_{41} = 8,8 \cdot 10^{-12}$m/V (631 nm)
- Direction of the light path: [1-10]
- Direction of the electric field: [110]
- On both [110]-surfaces of the crystal a chrome/(gold) film was vaporized
- Dimensions of the crystal 3 x 7 x 10 mm

Phase shift plate 2

- λ/4-phase shift plate
- Quartz
- Diameter 5 mm
- Thickness 3 mm or cube 3 x 3 x 3

Polarizers 1 and 4

Option 1 (the embodiment according to Fig. 10 - 11)

- Polarization cube
- Wave length: 830 nm
- Size: A = B = C = 5 mm

Option 2 (the embodiment according to Fig. 4 - 9)

- Polarization film
- Wave length: 830 nm
- Size: diameter 5 mm, thickness 1 mm.

Fibres 20:

Option 1 (Fig. 10 - 11)

- Ensign Pickford: HCP-MO400T-10
- Diameter of the core 400 μm
- Uncabled

Option 2 (Fig. 4 - 9)

- Ensign Pickford: HCP-MO200T-A02VZ-07
- 200/230 μm (core/coating)
- Cabled; double cabled

Potential dividing capacitors

- ceramical material Makor or
- polypropene or
- teflon
- diameter 40 mm, height 10 - 60 mm

Case

- Case material: cast plastic with resin filling, ceramics or teflon tube
- The structure of the sensor was designed fully isolative
- Fibres were attached to the case by means of ceramic ferrules. The ferrules were designed specially for this embodiment
- Selfoc microlenses were placed into glass ceramic cartridges
- Components were placed into a v-groove
- The crystal was designed so that its natural vibrations were quickly damped
- On the surfaces of the crystals chrome/gold films were vaporized
- As polarizers cube polarizers or film polarizers cut in an appropriate size and shape were used
- Inner cavities of the sensors were filled with silicone (table 1)

In the following, a table is represented that illustrates properties of insulating material 9 (glass ceramics) and silicone 5, applicable for the invention.

Table 1

| Material | Glass ceramics (MACOR) | Silicone |
|---|---|---|
| Type | | Sylgard 527 |
| GENERAL PROPERTIES | | |
| density kg/m$^3$ | 2520 | 970 |
| ELECTRICAL | | |
| RESISTIVITY ohm-cm | 1E+14 | 2.3E+15 |
| Extinction coefficient | 0.003 | 0.00015 |
| Dielectric constant | 5.9 | 2.95 |
| Voltage endurance kV/mm | 40 | 17 |
| HEAT | | |
| Thermal expansion ppm/K | 10 | 990 |
| Thermal conductivity W/mK | 1.68 | |
| Minimum temperature (C) | | -65 |
| Maximum temperature (C) | 1000 | 230 |
| MECHANICAL | | |
| Modulus of elasticity GN/m$^2$ | 65 | |
| Specific rigidity E/density | 2.60E+07 | |
| OPTICAL | | |
| Refractive index | | n. 1.5 |

Instead of the infrared radiation mentioned in the examples above also other wavelengths can be used in the invention.

## Claims

1. Optical voltage and electric field sensor (10,11) based on the Pockels effect, said sensor (10,11) comprising

   - a crystal (3) the distribution of refractive index of which alters when affected by an electric field,

   - wires (7) for leading the electric field onto the surface of the crystal (3),

   - polarizers (1,4) aligned on both sides of the crystal (3) and a phase shift plate (2) for detecting changes in the distribution of the refractive index, and

- optical fibres (20) for introducing light to and leading light from an optical path of the sensor formed by the polarizers (1,4), the phase shift plate (2), and the crystal (3),

characterized in that
the polarizers (1,4), the crystal(3), and the phase shift plate (2) are arranged in a cavity of the sensor (10,11) the remaining space of the cavity being filled up with silicone (5) in order to avoid air gaps inside the cavity of the sensor.

2. The field sensor as claimed in claim 1, characterized in that the silicone (5) has a refractive index of approximately 1.5, an extinction coefficient of approximately 0.00015, and a dielectric constant of approximately 2.95.

3. The field sensor as claimed in claim 1, characterized in that the wires (7) are gappedly aligned near the crystal (3), so that silicone (5) filling the gap acts as a structure damping the voltage/electric field to be measured.


**Patentansprüche**

1. Optischer Sensor (10, 11) für Spannung und elektrisches Feld basierend auf dem Pockels-Effekt, wobei der Sensor (10, 11) aufweist:

- einen Kristall (3), wobei sich die Verteilung von dessen Brechungsindex ändert, wenn er einem elektrischen Feld unterliegt,

- Drähte (7) zur Leitung des elektrischen Feldes auf die Oberfläche des Kristalls (3),

- an beiden Seiten des Kristalls (3) ausgerichtete Polarisierer (1, 4) und eine Phasenverschiebungsplatte (2) zur Erfassung von Änderungen der Verteilung des Brechungsindex, und

- optische Fasern (20) zum Einführen von Licht in und Wegführen von Licht von einem optischen Weg des durch die Polarisierer (1, 4), die Phasenverschiebungsplatte (2) und den Kristall (3) gebildeten Sensors,

**dadurch gekennzeichnet,** daß die Polarisierer (1, 4), der Kristall (3) und die Phasenverschiebungsplatte (2) in einem Hohlraum des Sensors (10, 11) angeordnet sind, wobei der verbleibende Raum des Hohlraumes mit Silikon (5) aufgefüllt ist, um Lufträume innerhalb des Hohlraums des Sensors zu vermeiden.

2. Feldsensor gemäß Anspruch 1,
**dadurch gekennzeichnet,** daß das Silikon (5) einen Brechnungsindex von ungefähr 1,5, einen Extinktionskoeffizienten von ungefähr 0,00015 und eine Dielektrizitätskonstante von ungefähr 2,95 aufweist.

3. Feldsensor gemäß Anspruch 1,
**dadurch gekennzeichnet,** daß die Leitungen (7) mit einer Lücke nahe dem Kristall (3) angeordnet sind, so daß das die Lücke füllende Silikon (5) als Bauelement dient, das die/das zu messende Spannung/elektrische Feld dämpft.


**Revendications**

1. Capteur de tension et de champ électrique optique (10,11) basé sur l'effet Pockels, ledit capteur (10,11) comprenant :

un cristal (3) dont la distribution d'indice de réfraction varie lorsqu'il est affecté par un champ électrique,
des conducteurs (7) pour amener le champ électrique sur la surface du cristal (3),
des polariseurs (1,4) alignés sur les deux côtés du cristal (3) et une plaque de déphasage (2) pour détecter les changements de la distribution de l'indice de réfraction, et
des fibres optiques (20) pour introduire une lumière dans un chemin optique et conduire une lumière hors de ce chemin optique du capteur formé par les polariseurs (1,4), la plaque de déphasage (2) et le cristal (3), caractérisé en ce que :
les polariseurs (1,4), le cristal (3) et la plaque de déphasage (2) sont agencés dans une cavité du capteur (10,11), l'espace restant de la cavité étant rempli de silicone (5) afin d'éviter des intervalles d'air à l'intérieur de la cavité du capteur.

2. Capteur de champ suivant la revendication 1, caractérisé en ce que la silicone (5) a un indice de réfraction de 1,5 environ, un coefficient d'extinction de 0,00015 environ et une constante diélectrique de 2,95 environ.

3. Capteur de champ suivant la revendication 1, caractérisé en ce que les conducteurs (7) sont alignés à intervalles près du cristal (3), de sorte que la silicone (5) remplissant l'intervalle agit comme une structure amortissant la tension/le champ électrique à mesurer.

Fig. 1

Fig. 2

Fig. 3

I in                                                    I out

Fig. 4

1   2   3           4

Fig. 5

I in                                    I out

5

7

6

9

16

7

1   2   3   4

Fig. 6

Fig. 7

Fig. 8

EP 0 641 444 B1

Fig. 9

Fig. 10

Fig. 11